# EUROPEAN PATENT APPLICATION

(11) **EP 3 629 690 A1**
(43) Date of publication of application: **01.04.2020**
(21) Application number: 19199342.7
(22) Date of filing: 24.09.2019
(51) Int. Cl.: H05K 7/20

(54) **COLD PLATE FOR POWER MODULE**

(30) Priority: 25.09.2018 US 201816141423
(71) Applicant: GE Aviation Systems LLC, Grand Rapids, MI 49512 (US)
(72) Inventor: HERNANDEZ-TOLEDO, Osmel, Grand Rapids, MI Michigan 49512 (US)
(74) Representative: Openshaw & Co.

(57) **Abstract**

A cold plate (70) and method for manufacturing the cold plate (70) for cooling an electronic component includes a monolithic body (100) comprising a housing (102) having an exterior (144) and defining an interior (104), a cooling passage (106) disposed within the interior (104) comprising at least one inlet (110) and at least one outlet (112) wherein the at least one inlet (110) and the at least one outlet (112) are disposed on the exterior (144), and a connecting conduit (108) extending between the at least one inlet (110) and the at least one outlet (112), and at least one plenum chamber (106a, 106b, 106c) and a phase change material located within the at least one plenum chamber (106a, 106b, 106c).

## Description

### TECHNICAL FIELD

The disclosure generally relates to a thermal management system and more specifically to a cold plate within an electronics chassis.

### BACKGROUND

Contemporary power systems, including those utilized in aircraft, take the form of avionic packages, to implement a multitude of features such as but not limited to controlling, distribution, and powering, various electrical equipment and operations required for flying the aircraft. The avionics typically includes electronic components, mounted on multiple circuit boards. The circuit boards can be packaged in an electronic chassis, which performs several beneficial functions including protecting the avionics from environment exposure, lightning strikes, and it can also be used to dissipate the heat generated by the electronic components.

The functional design of the electronic components incorporate the control and conversion features required of electrical power. This conversion is typically performed by silicon, silicon carbide, and gallium nitride semiconductor devices that are packaged into power modules. One of the factors associated with power modules is the dissipation of heat. While the heat dissipated by the power modules is due to many factors, it generally relates to an efficiency loss, typically generated as heat. Increased temperatures can result in an erosion of power module performance and/or reliability. Heat dissipation in avionics, is addressed through thermal management techniques.

An additional factor for thermal management relates to the packaging of a number of devices in small footprints. The power density, at which the devices, and thus the module can operate, therefore depends on the ability to remove this generated heat. A common form of thermal management of power electronics is through cold plates. Cold plates operate by transferring the heat away from the heat source of the power module, thereby maintaining and protecting the heat source with a lower relative temperature. There are various types of cold plates known in the thermal management field including air-cooled and liquid-cooled devices.

One example of the thermal management of a power module includes the attachment of a cold plate with embedded tubes to provide liquid cooling of the power module. The cold plate is typically a metallic structure, such as aluminum or copper. A coolant such as water is passed through the tubes, or internal milled channels, to cool the power module. Typically the cold plate is coupled to the power module base with a thermal interface material (TIM) dispersed there between. The thermal interface material may comprise thermal greases, compliant thermal pads, or the like, to increase the thermal efficiency of a metal to metal interface.

Avionics can produce very high steady state heat loads (in the kilowatt range), and it can be beneficial to utilize cooling devices such as a cold plate for managing and protecting the avionics in operation.

### BRIEF DESCRIPTION

In one aspect, the disclosure relates to a cold plate comprising a monolithic body comprising a housing having an exterior and defining an interior, a cooling passage disposed within the interior comprising at least one inlet and at least one outlet wherein the at least one inlet and the at least one outlet are disposed on the exterior, and a connecting conduit extending between the at least one inlet and the at least one outlet, and at least one plenum chamber fluidly isolated from and in parallel with at least a portion of the cooling passage and comprising at least one access opening, and a phase change material located within the at least one plenum chamber.

In another aspect, the disclosure relates to a cold plate comprising a monolithic body having a first material forming a housing with a serpentine cooling conduit and at least one plenum chamber in parallel with at least a portion of the serpentine cooling conduit; and a phase change material located within the plenum chamber.

### BRIEF DESCRIPTION OF THE DRAWINGS

In the drawings:
FIG. 1 is a perspective view of an aircraft having an electronics chassis including an avionics system in accordance with various aspects described herein.
FIG. 2 is a perspective view of the electronics chassis from FIG. 1 including a cold plate in accordance with an aspect of the disclosure described herein.
FIG. 3 is a perspective view of the cold plate of FIG. 2 including a fluid based cooling passage forming an internal serpentine cooling conduit and plenum chambers for a phase change material, in parallel with portions of the cooling passage.
FIG. 4 is the same perspective view of FIG. 3 with the plenum chambers full of a phase change material.
FIG. 5 is an exemplary manifold system with the cold plate of FIG. 2 attached to a heat generating module, in accordance with another aspect of the disclosure herein.

### DETAILED DESCRIPTION

Aspects of the present disclosure describe an approach to form and utilize a cold plate with plenum chamber(s) for holding phase change material. For the purposes of illustration, the cold plate of the present disclosure will be described with respect to an aircraft system. It will be understood that the present disclosure is not so limited and can have general applicability in non-aircraft applications, including solar power distribution systems, as well as in other mobile or non-mobile applications, including other air-based, land-based, or marine-based applications.

The cold plate as disclosed herein is a compact thermal management solution that can be modularized and tuned in development to an array of steady state and transient power load conditions. In some electronic applications, a transient power load condition can augment and spike above the steady state heat load. For example when a pulse load occurs in laser applications. While illustrated in an avionics chassis, it should be understood that the cold plate as disclosed herein has applicability in numerous applications and is not so limited. Integration of phase change material and coolant conduits, specifically in a parallel arrangement, can increase the capabilities of a cold plate in terms of thermal performance and required specifications, as well as offer weight savings, and minimized complexity by eliminating a need for two independent systems. The cold plate and method for manufacturing the cold plate described herein, relies on simultaneous but independent cooling techniques. The cold plate has an inlet and outlet to serve the purpose of a traditional liquid cooled cold plate, however, the cold plate also incorporates a reservoir filled with a phase change material, to address transient peak load conditions as required.

While "a set of' various elements will be described, it will be understood that "a set" can include any number of the respective elements, including only one element. Additionally, all directional references (e.g., radial, axial, upper, lower, upward, downward, left, right, lateral, front, back, top, bottom, above, below, vertical, horizontal, clockwise, counterclockwise) are only used for identification purposes to aid the reader's understanding of the disclosure, and do not create limitations, particularly as to the position, orientation, or use thereof. Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. The exemplary drawings are for purposes of illustration only and the dimensions, positions, order and relative sizes reflected in the drawings attached hereto can vary.

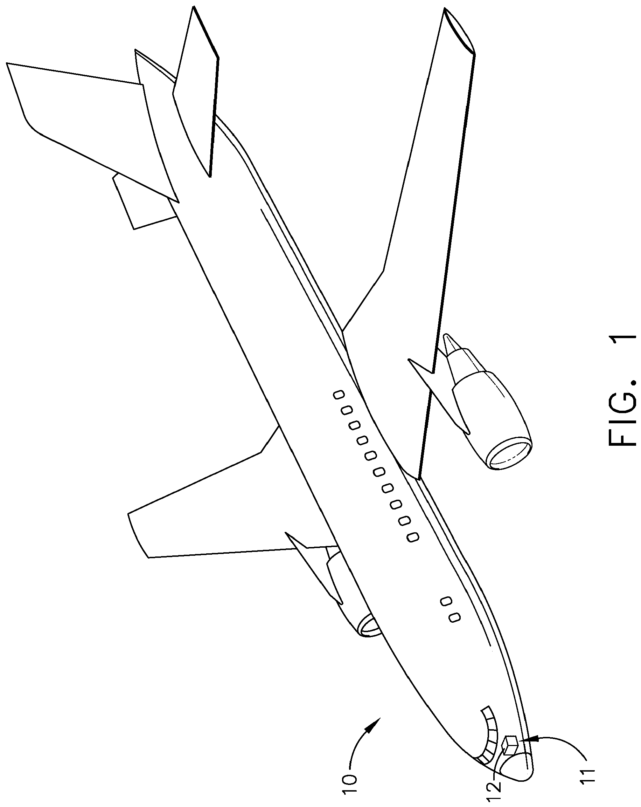

FIG. 1 schematically illustrates an aircraft 10 with a thermal management member 11, illustrated as an on-board electronics chassis 12 for housing avionics or avionics components for use in the operation of the aircraft 10. It will be understood that the thermal management member 11 can also include heat spreaders, heat sinks, heat exchanger, radiators, or heat pipes in non-limiting examples. The electronics chassis 12 can house a variety of avionics elements and protects them against contaminants, electromagnetic interference (EMI), radio frequency interference (RFI), vibrations, and the like. Alternatively or additionally, the electronics chassis 12 can have a variety of avionics mounted thereon. It will be understood that the electronics chassis 12 can be located anywhere within the aircraft 10, not just the nose as illustrated.

While illustrated in a commercial airliner, the electronics chassis 12 can be used in any type of aircraft, for example, without limitation, fixed-wing, rotating-wing, rocket, commercial aircraft, personal aircraft, and military aircraft. Furthermore, aspects of the disclosure are not limited only to aircraft aspects, and can be included in other mobile and stationary configurations. Non-limiting example mobile configurations can include ground-based, water-based, or additional air-based vehicles.

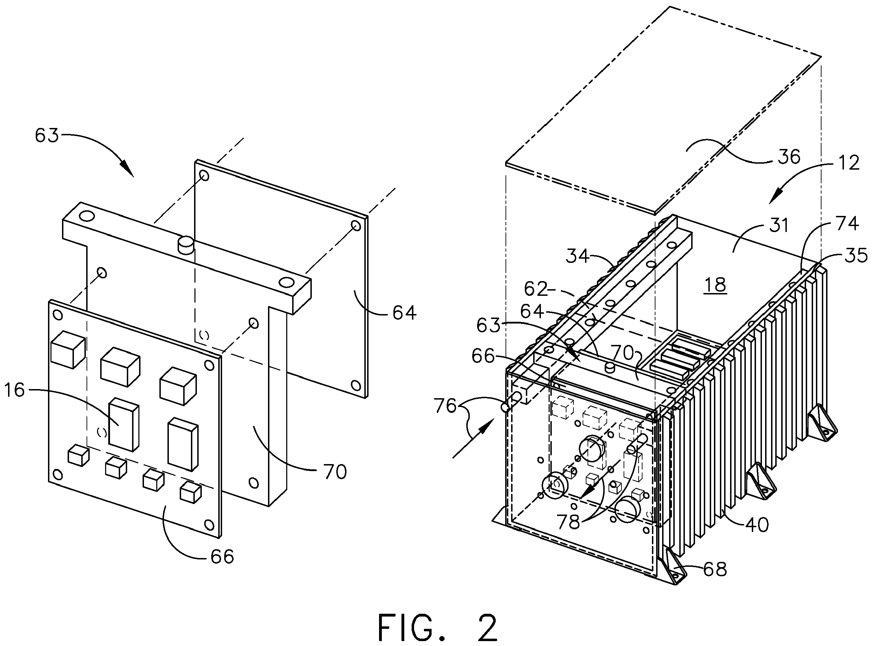

FIG. 2 illustrates the electronics chassis 12 in further detail, where the electronics chassis 12 can include a chassis housing 16 defining an interior 18 and exterior 20. The electronics chassis 12 can include a chassis frame 30 having a back wall 31, and opposing sidewalls 34, 35. The chassis frame 30 can further include a removable cover 36, providing access to the interior 18 of the electronics chassis 12 when removed, and at least partially restricting access to the interior 18 when coupled or mounted to the chassis frame 30. The frame can be formed from any suitable material, such as aluminum or steel in non-limiting examples.

Further still, a set of fins 40 can project from the sidewalls 34, 35. The set of fins 40 can also be formed of any suitable material including aluminum or steel. While the set of fins 40 are shown on the sidewalls 34, 35, the set of fins 40 can be disposed on any exterior portion of the electronics chassis 12, such as the cover 36 or the back wall 31 in additional non-limiting examples. While the set of fins 40 are shown extending fully along the sidewalls 34, 35, it should be appreciated that the set of fins 40 need not extend the full length of the sidewalls 34, 35, and can be organized in other configurations.

An avionics system 63 including at least one avionics system card 64 can be housed within the electronics chassis 12, wherein the avionics system 63 can be configured to slide into the interior 18. Each avionics system card 64 can include a set of wires. The set of wires can be formed of any suitable material, including copper or aluminum. Furthermore, at least one heat-producing electronic component 66 can be included on the avionics system card 64. It should be understood that the set of wires can be used within the electronic component 66, or to connect multiple electronic components 66, or anywhere else within or on the avionics system card 64 as desired. In addition, while only one avionics system card 64 is shown, the electronics chassis 12 can be configured to house, support, or include any number of avionics system cards 64.

The avionics system 63 can further include a cold plate 70 illustrated as being provided within the electronics chassis 12 and thermally coupled to the avionics system card 64 such that heat can move away from the electronic component 66 via the cold plate 70 out of the chassis 12 through the set of fins 40. By way of non-limiting example, it is contemplated that air can be provided along the set of fins 40 to move the heat away. It is further contemplated that heat introduced to the exterior 20 of the electronics chassis 12 can dissipate by convection as well.

The cold plate 70 can be fluidly connected to an inlet plenum 72 and outlet plenum 74 for receiving and emitting liquid coolant as it passes through the cold plate 70. The liquid coolant can be introduced to the inlet plenum 72 via a fluid inlet 76 and exit the outlet plenum 74 via a fluid outlet 78. It is contemplated that multiple avionics system cards 64 are stacked within the interior 18 of the electronics chassis with multiple cold plates 70 in such a manner that the cold plates 70 are "sandwiched" but avionics system cards 64.

A set of mounting feet 68 can extend from the chassis housing 16 to facilitate mounting the electronics chassis 12 to the aircraft 10 by means of bolts or other suitable fasteners. Further, the set of mounting feet 68 can function as an electrical ground to ground the electronics chassis 12 to the frame of the aircraft 10. While the set of mounting feet 68 are shown in this example, the electronics chassis 12 can be used with any desired type of attachment mechanism.

As used herein, a set of vectors will be used to describe orientation of the cold plate 70 with respect to the electronics chassis 12. For ease of understanding, a coordinate axis system is included to describe aspects of the disclosure. As used in FIG. 2, "X" will refer to a lateral direction or axis, such as parallel to the ground and in a direction of side to side. Additionally, "Y" will refer to another axis or direction substantially vertical and orthogonal to the X axis, and "Z" will refer to a vertical axis or direction orthogonal to both the X axis and the Y axis and substantially into and out of the page.

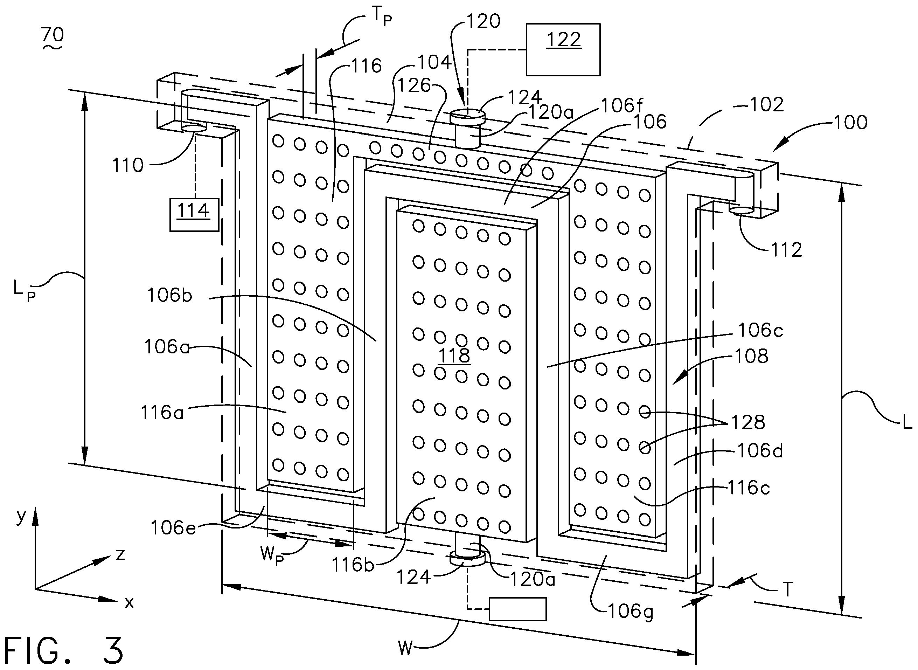

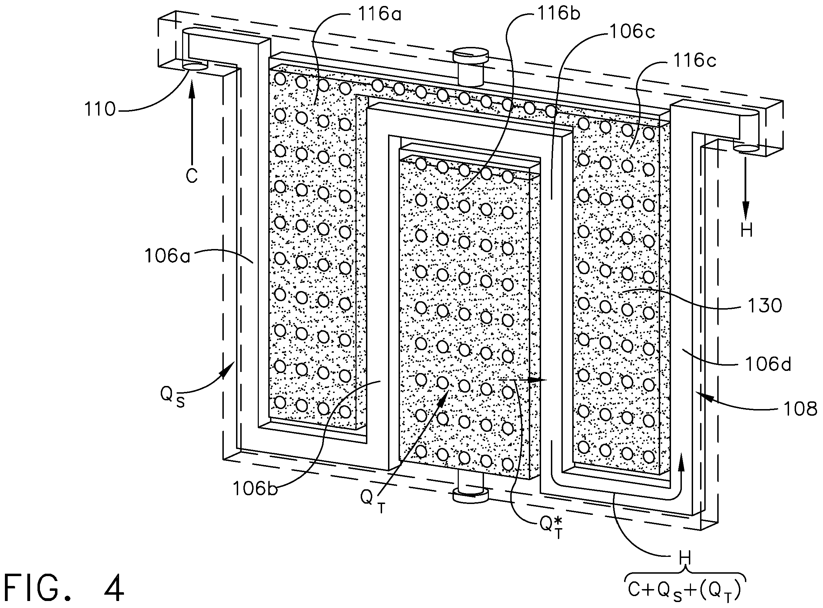

Referring now to FIG. 3, the cold plate 70 is illustrated in further detail. The XYZ axis is available to help orient and more clearly describe the cold plate 70 of FIG. 2. The cold plate 70 includes a monolithic body 100 having a housing 102 illustrated in dashed line to reveal an interior 104 defined by the housing 102. By "monolithic" it should be understood that the housing 102 and all parts located within the housing 102 are formed as a single unit from the same material. The housing 102 can extend along the Y axis a length (L) and along the X axis a width (W) and along the Z axis a thickness (T). It should be understood that the length (L), width (W), and thickness (T) are variable and dependent on design requirements. A cooling passage 106 is disposed within the housing 102 to define a serpentine cooling conduit 108 through the interior 104. The serpentine cooling conduit 108 can be engineered to accommodate a steady state heat load (Qs) (FIG. 4). The serpentine cooling conduit 108 can be a connecting conduit extending between an inlet 110 and an outlet 112 of the cooling passage 106. The inlet 110 can be coupled to any appropriate liquid coolant supply 114, by way of non-limiting any suitable liquid for the environment of the cold plate 70, such as ethylene glycol water (EGW) or propylene glycol water (PGW).

The serpentine cooling conduit 108 includes a first 106a, second 106b, third 106c, and fourth 106d portion of the cooling passage 106 extending substantially along the Y axis and a fifth 106e, sixth 106f, and seventh 106g portion of the cooling passage 106 extending substantially along the X axis between the first 106a and second 106b, second 106b and third 106c, and third 106c and fourth 106d portions of the cooling passage 106 respectfully. The fifth 106e, sixth 106f, and seventh 106g portions of the cooling passage 106 fluidly connect the first 106a, second 106b, third 106c, and fourth 106d portions of the cooling passage 106 respectfully. The first 106a, second 106b, third 106c, and fourth 106d portions of the cooling passage 106 are spaced from each other along the X axis a distance greater than or equal to a plenum width (Wp). The fifth 106e, sixth 106f, and seventh 106g portions of the cooling passage can each extend along the X axis a distance greater than or equal to at least one plenum width (Wp). Furthermore, the sixth 106f portion of the cooling passage 106 is spaced from the fifth 106e and seventh 106g portions of the cooling passage 106 along the Y axis a distance less than or equal to the housing length (L). In other words, the serpentine cooling conduit 108 snakes back and forth while moving along the X axis from the inlet 110 to the outlet 112.

At least one plenum chamber 116 can be disposed between the first 106a and second 106b portions of the cooling passage 106 filling in the space defined by the plenum width (Wp) to form a fluidly isolated cavity 118 from the cooling passage 106. The fluidly isolated cavity 118 can have a volume equal to or slightly smaller than a volume defined by the plenum width (Wp), a plenum thickness (Tp), and a plenum length (Lp). It should be understood that the plenum thickness (Tp) and plenum length (Lp) have maximum values equal to the housing thickness (T) and housing length (L). The at least one plenum chamber is oriented in parallel with at least one of the first 106a, second 106b, third 106c, and forth 106d portions of the cooling passage 106. By way of non-limiting example the at least one plenum chamber 116 can be multiple plenum chambers, a first, second, and third plenum chamber 116a, 116b, 116c, provided between the corresponding cooling passage portions 106a, 106b, 106c, 106d respectfully. The serpentine cooling conduit 108, therefore, extends between sequentially placed plenum chambers 116a, 116b, 116c. It should be understood that while illustrated as oriented parallel to the length (L) portions of the serpentine cooling conduit 108, the parallel orientation can be with respect to the width (W) portion and is shown for illustrative purposes only and not meant to be limiting.

At least one access opening 120, illustrated as two access openings 120a, 120b, provides a fluid connection between the fluidly isolated cavity 118 of the at least one plenum chamber 116 and a phase change material (PCM) source 122. The at least one access opening 120 can be opened and closed by a cap 124 or any suitable lid or cover capable of opening and closing the at least one access opening 120 for access to the at least one plenum chamber 116. By way of non-limiting example, the first and third plenum chambers 116a, 116c are fluidly connected via a plenum connector 126 extending along the X axis and spaced above the sixth portion 106f of the cooling passage 106. A first access opening 120a can be provided at the plenum connector 126. A second access opening 120b can be provided at the second chamber 116b in order to provide a fluid connection between the fluidly isolated cavity 118 of the second plenum chamber 116b and the PCM source 122. It should be understood that any number of access openings 120 are contemplated, by way of non-limiting example three access openings can be connected to each of the plenum chambers individually. The PCM source 122 can provide an organic PCM, by way of non-limiting example paraffin carbon. It should be noted that the PCM provided by the PCM source 122 is not the same liquid coolant passing through the cooling passage 106. The PCM has a higher melting point, by way of non-limiting example between 20 and 70 degrees Celsius higher, than the liquid coolant passing through the cooling passage 106. The PCM can be filled to between 60 and 100% capacity of the at least one plenum chamber 116 depending on the expansion volume of the PCM used.

The monolithic body 100 can be additively manufactured such that the cooling passage 106 and the at least one plenum chamber 116 are 3D printed as one piece enclosed within the housing 102. Reinforcement pegs 128 can extend along the Z axis through at least a length equal to or less than the thickness (T) of the housing 102The reinforcement pegs can serve a dual purpose. The reinforcement pegs 128 can provide structural wall reinforcement stability to the at least one plenum chamber 116 during expansion of the PCM and the reinforcement pegs 128 can evenly conduct external power dissipation across the PCM within the at least one plenum chamber 116.

A method for manufacturing the cold plate 70 as described herein includes printing from a first material the monolithic body 100. The first material can be a metal alloy, by way of non-limiting example an aluminum, copper, silver, or silver/copper alloy. The monolithic body 100 is printed with the serpentine cooling conduit 108 and the at least one plenum chamber 116 positioned in parallel with the portions of the cooling passage 106. Furthermore the internal structure including the reinforcement pegs 128 can also be included in the printing, resulting in a monolithic body 100, that is one piece customized for the application in which it will be used and with the internal details as described herein.

Turning to FIG. 4, the cold plate 70 is illustrated with the at least one plenum chamber 116 filled with a PCM 130. By way of non-limiting example all three plenum chambers 116a, 116b, 116c are filled with the PCM 130. The method further includes filling the at least one plenum chamber 116 with the PCM 130 for a temporary amount of time. In other words, the fluid connection between the at least one plenum chamber and the PCM source 122 is limited to only the time necessary to fill the at least one plenum chamber 116.

During operation, liquid coolant (C) is received through the inlet 110 and passes through the serpentine cooling conduit 108. The liquid coolant (C) along with the geometry of the serpentine cooling conduit 108 are designed to withstand steady state heat loads (Qs) received from power sources, by way of non-limiting example the avionics system card 64 (FIG. 2). The steady state heat load (Qs) is received in the liquid coolant (C) such that a heated coolant (H) is emitted from the outlet and the avionics system card 64 is cooled. During a transient heat load, by way of non-limiting example a small period or burst of electrical output by the avionics system card 64, given off increases momentarily forming a transient state heat load (Qt). It is during the transient state heat load (Qt) that the PCM 130 receives an excess heat (Qt*) and stores the excess heat (Qt*) until the transient load has ended, at which time the PCM 130 releases the excess heat (Qt*) into the parallel oriented cooling passage portions 106a, 106b, 106c, 106d and emits the excess heat (Qt*) via the outlet as heated coolant (H) to be carried away from the avionics system card 64.

The steady state heat load (Qs) can be within the thermal capacity of the liquid coolant (C). When a higher dissipating pulse load occurs, from by way of non-limiting example a laser, an amount equal to the steady state heat load (Qs) will dissipate into the liquid coolant (C) and the PCM can address the additional, or transient state heat load (Qt) and the temporary heat, or excess heat (Qt*) that occurs.

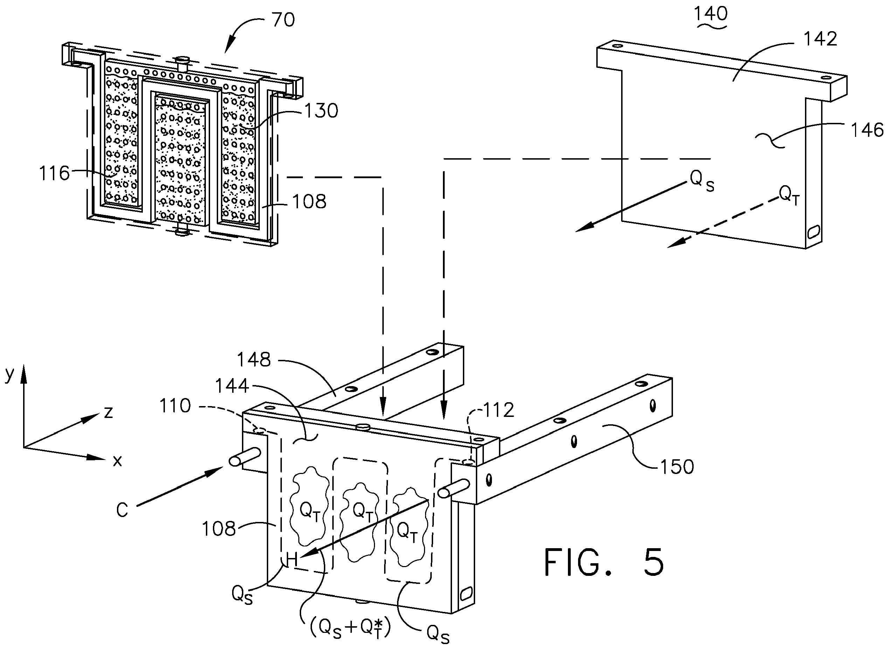

FIG. 5 illustrates an exemplary manifold system 140 with the cold plate 70 attached to a heat generating module 142. The cold plate 70 can be printed to mimic the shape of any power source, by way of non-limiting example the heat generating module 142 as illustrated. The heat generating module 142 can be a power module or battery module, or any suitable power source such as the avionics system card 64. The cold plate 70 and heat generating module 142 can be stacked sequentially next to each other such that an exterior 144 of the cold plate 70 is in contact with an exterior 146 of the heat generating module 142. The cold plate 70 can be fluidly connected to an inlet plenum 148 and outlet plenum 150 for receiving and emitting the liquid coolant (C) as it passes through the serpentine cooling conduit 108. As described herein it should be understood that heat received into the cold plate 70 during normal operation of the heat generating module 142 is received by the cold plate 70 as the steady state heat load (Qs). This steady state heat load (Qs) is carried by the liquid coolant (C) through the serpentine cooling conduit 108, and is emitted via the outlet as the heated coolant (H). In a transient load condition, when the heat generating module 142 is being utilized to send pulses or to operate a laser intermittently, a transient state heat load (Qt) is received and stored in the PCM 130 until the transient load condition has passed. The transient heat load (Qt) is then transferred into the serpentine cooling conduit 108 and received by the liquid coolant (C). The heated coolant (H) emitted after a transient load condition can include at least a portion of the excess heat (Qt*) produced during the transient load condition for any appropriate period of time until all of the excess heat (Qt*) has been dissipated.

A method for cooling the power module 140 using the cold plate 70 includes flowing the liquid coolant (C) through the serpentine cooling conduit 108 from the inlet 110 to the outlet 112. The method further includes storing the PCM 130 within the at least one plenum chamber oriented parallel to a portion of the serpentine cooling conduit 108. The steady state load (Qs) is received by the liquid coolant (C) within the serpentine cooling conduit 108. During a variant power surge, as described herein, the transient state heat load (Qt) is received by the PCM 130 and stored in the PCM 130 located within the at least one plenum chamber 116. The method further includes transferring the stored transient state heat load, or excess heat (Qt*) as described herein, to the liquid coolant (C) upon completion of the power surge.

Aspects of the present disclosure provide for a variety of benefits. The variable sized modular cold plate disclosed herein includes a coolant inlet, outlet, and paths, which functions to manage the steady state thermal loading under normal operating conditions. Additionally the cold plate disclosed herein is capable of handling transient thermal loads such that the excess heat received during the transient thermal load dissipates out of a PCM such as paraffin only after the transient thermal load has ended. The disclosure as described herein can accommodate a variety of PCMs that exist today, as well as future PCM materials.

Simultaneously accepting transient thermal loads which can produce short high power heat dissipation from, for example, a pulse load is accomplished by internally interleaving a PCM such as paraffin, to absorb transient heat loads above the steady state condition. Additively manufacturing the housing itself enables a complex and evenly interleaved internal plenum chambers, to enable both thermal management capabilities, steady state and transient state, to be tuned any requirements of the power module to which the cold plate is mounted or attached.

Integrating both capabilities together in an effective and efficient compact unit reduces volume to the required specifications, while meeting performance requirements.

Other possible configurations in addition to those shown in the above figures are contemplated by the present disclosure. To the extent not already described, the different features and structures of the various aspects can be used in combination with others as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

This written description uses examples to illustrate aspects of the disclosure, including the best mode, and also to enable any person skilled in the art to practice aspects of the disclosure, including making and using any devices or systems and performing any incorporated methods. The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

Further aspects of the invention are provided by the subject matter of the following clauses:
1. A cold plate comprising a monolithic body comprising a housing having an exterior and defining an interior, a cooling passage disposed within the interior comprising at least one inlet and at least one outlet wherein the at least one inlet and the at least one outlet are disposed on the exterior, and a connecting conduit extending between the at least one inlet and the at least one outlet, and at least one plenum chamber fluidly isolated from and in parallel with at least a portion of the cooling passage and comprising at least one access opening; and a phase change material located within the at least one plenum chamber.
2. The cold plate of any preceding clause wherein the at least one plenum chamber comprises multiple plenum chambers.
3. The cold plate of any preceding clause wherein the connecting conduit comprises a serpentine cooling conduit extending back and forth relative to at least one dimension of the housing.
4. The cold plate of any preceding clause further comprising a power source in stacked relationship with the cold plate to collectively define a power module.
5. The cold plate of any preceding clause wherein the power module includes an inlet plenum and an outlet plenum fluidly coupled to the at least one inlet and the at least one outlet.
6. The cold plate of any preceding clause wherein the power module is located within an avionics chassis.
7. The cold plate of any preceding clause wherein the at least one plenum chamber is fluidly coupled to a phase change material source via an access opening.
8. The cold plate of any preceding clause wherein a liquid coolant different than the phase change material flows through the cooling passage.
9. The cold plate of any preceding clause wherein the monolithic body is additively manufactured.
10. A cold plate comprising: a body having a first material forming a housing with a serpentine cooling conduit and at least one plenum chamber in parallel with at least a portion of the serpentine cooling conduit; and a phase change material located within the plenum chamber.
11. The cold plate of any preceding clause wherein the at least one plenum chamber comprises multiple plenum chambers.
12. The cold plate of any preceding clause further comprising a power source in stacked relationship with the cold plate to collectively define a power module.
13. The cold plate of any preceding clause wherein the serpentine cooling conduit extends back and forth relative to at least one dimension of the housing between at least one outlet and at least one inlet.
14. The cold plate of any preceding clause wherein the power module includes an inlet plenum and an outlet plenum fluidly coupled to the at least one inlet and the at least one outlet.
15. The cold plate of any preceding clause wherein the power module is located within an avionics chassis.
16. The cold plate of any preceding clause wherein the plenum chamber further includes an access opening fluidly connected to a phase change material source for a temporary amount of time.
17. The cold plate of any preceding clause wherein a liquid coolant different than the phase change material flows through the cooling passage.
18. The cold plate of any preceding clause wherein the body is a monolithic body that is additively manufactured.
19. A method for manufacturing a cold plate the method comprising printing from a first material a monolithic body with a serpentine cooling conduit and a plenum chamber in parallel with at least a portion of the serpentine cooling conduit; and filling the plenum chamber with a phase change material.
20. The method of any preceding clause further comprising forming reinforcement pegs within the plenum chamber.

## Claims

1. A cold plate (70) comprising:
a monolithic body (100) comprising:
a housing (102) having an exterior (144) and defining an interior (104),
a cooling passage (106) disposed within the interior (104) comprising at least one inlet (110) and at least one outlet (112) wherein the at least one inlet (110) and the at least one outlet (112) are disposed on the exterior (144), and a connecting conduit (108) extending between the at least one inlet (110) and the at least one outlet (112), and
at least one plenum chamber (106a, 106b, 106c) fluidly isolated from and in parallel with at least a portion of the cooling passage (106) and comprising at least one access opening (120, 120a, 120b); and
a phase change material (130) located within the at least one plenum chamber (106a, 106b, 106c).

2. The cold plate (70) of claim 1 wherein the at least one plenum chamber (106a, 106b, 106c) comprises multiple plenum chambers (106a, 106b, 106c),

3. The cold plate (70) of any of claims 1-2 wherein the connecting conduit (108) comprises a serpentine cooling conduit (108) extending back and forth relative to at least one dimension (L, W) of the housing (102).

4. The cold plate (70) of any of claims 1-3 further comprising a power source in stacked relationship with the cold plate (70) to collectively define a power module (142).

5. The cold plate (70) of any of claims 1-4 wherein the power module (142) includes an inlet plenum (148) and an outlet plenum (150) fluidly coupled to the at least one inlet (110) and the at least one outlet (112).

6. The cold plate (70) of any of claims 1-5 wherein the power module (142) is located within an avionics chassis (12).

7. The cold plate (70) of any of claims 1-6 wherein the at least one plenum chamber (106a, 106b, 106c) is fluidly coupled to a phase change material source (122) via an access opening (120, 120a, 120b).

8. The cold plate (70) of any of claims 1-7 wherein a liquid coolant (C) different than the phase change material (130) flows through the cooling passage (106).

9. The cold plate (70) of any of claims 1-8 wherein the monolithic body (100) is additively manufactured.

10. A cold plate (70) comprising: a body (100) having a first material forming a housing (120) with a serpentine cooling conduit (108) and at least one plenum chamber (106a, 106b, 106c) in parallel with at least a portion of the serpentine cooling conduit (108); and a phase change material (130) located within the plenum chamber (106a, 106b, 106c).

11. The cold plate (70) of claim 10 wherein the at least one plenum chamber (106a, 106b, 106c) comprises multiple plenum chambers (106a, 106b, 106c).

12. The cold plate (70) of any of claims 10-11 further comprising a power source (64) in stacked relationship with the cold plate (70) to collectively define a power module (142).

13. The cold plate (70) of any of claims 10-12 wherein the serpentine cooling conduit (108) extends back and forth relative to at least one dimension of the housing (120) between at least one outlet (110) and at least one inlet (112).

14. The cold plate (70) of any of claims 10-13 wherein the power module (142) includes an inlet plenum and an outlet plenum fluidly coupled to the at least one inlet (110) and the at least one outlet (112).

15. The cold plate (70) of any of claims 10-14 wherein the power module (142) is located within an avionics chassis (12).
